Europäisches Patentamt

European Patent Office

Office européen des brevets

(11) Veröffentlichungsnummer: **0 178 431**
**B1**

(12) **EUROPÄISCHE PATENTSCHRIFT**

(45) Veröffentlichungstag der Patentschrift:
28.02.90

(51) Int. Cl.⁴: **G01R 31/28, H01J 49/44**

(21) Anmeldenummer: 85110581.7

(22) Anmeldetag: 22.08.85

(54) **Gegenfeld-Spektrometer für die Elektronenstrahl-Messtechnik.**

(30) Priorität: 18.09.84 DE 3434231

(43) Veröffentlichungstag der Anmeldung:
23.04.86 Patentblatt 86/17

(45) Bekanntmachung des Hinweises auf die Patenterteilung:
28.02.90 Patentblatt 90/9

(84) Benannte Vertragsstaaten:
DE FR GB IT NL

(56) Entgegenhaltungen:
US-A- 4 460 866
US-A- 4 464 571

(73) Patentinhaber: ICT Integrated Circuit Testing
Gesellschaft für Halbleiterprüftechnik mbH,
Klausnerring 1a, D-8011 Heimstetten(DE)

(72) Erfinder: Feuerbaum, Hans-Peter, Dr.,
Arno-Assmann-Strasse 14, D-8000 München 83(DE)

(74) Vertreter: Tetzner, Volkmar, Dr.-Ing. Dr. jur.,
Van-Gogh-Strasse 3, D-8000 München 71(DE)

## Beschreibung

Die Erfindung betrifft ein elektrostatisches Gegenfeld-Spektrometer nach dem Oberbegriff des Anspruchs 1.

Die Potentialmessung an Meßpunkten auf Probenoberflächen, insbesondere die quantitative Potentialmessung an Leitbahnen und an Schaltungsknoten von integrierten mikroelektronischen Bauelementen, mit Hilfe der Elektronenstrahl-Meßtechnik erfordert ein Spektrometer für die Sekundärelektronen.

In einem Elektronenstrahl-Meßgerät werden die zu vermessenden Meßpunkte auf einer Probenoberfläche, z.B. Leitbahnen von integrierten mikroelektronischen Bauelementen, mit Primärelektronen bestrahlt, wobei unter anderem Sekundärelektronen ausgelöst werden. Je nach Potential der vermessenen Leitbahn wird die Energieverteilungsfunktion der Sekundärelektronen verändert. In einem Spektrometer für Sekundärelektronen kann man diese Veränderung der Energieverteilungsfunktion der Sekundärelektronen und damit das Potential des vermessenen Meßpunktes auf der Probenoberfläche ermitteln. Der grundsätzliche Aufbau und der Gebrauch eines solchen Gegenfeld-Spektrometers für die Elektronenstrahl-Meßtechnik sind in der US-Patentschrift US-A 4 460 866 beschrieben.

Von H. P. Feuerbaum ist aus der Veröffentlichung in 'Scanning Electron Microscopy'/1979 / I, S.285-296, ein elektrostatisches Gegenfeld-Spektrometer bekannt, welches jedoch nicht die ganze Raumwinkelverteilung der am Meßpunkt auf der Probenoberfläche ausgelösten Sekundärelektronen transmittieren kann. Dieser Meßfehler rührt hauptsächlich daher, daß ein mit einer bestimmten Energie schräg gegen das ebene Gegenfeld-Netz anlaufendes Elektron das Gegenfeld-Gitter unter Umständen nicht mehr passieren kann, während ein senkrecht zum Gegenfeld-Netz startendes Elektron gleicher Energie dieses Gegenfeld-Netz gerade noch passieren kann.

Aus der US-Patentschrift US-A 4 464 571 ist ein elektrostatisches Gegenfeld-Spektrometer mit einer Absaug-Elektrode und mit einer Gegenfeld-Elektrode bekannt, das zur Berücksichtigung der Raumwinkelverteilung der am Meßpunkt auf der Probenoberfläche ausgelösten Sekundärelektronen zwei kugelsymmetrische Elektrodenanordnungen besitzt. Diese beiden kugelsymmetrischen Elektrodenanordnungen erzeugen ein kugelsymmetrisches Gegenfeld. Die beiden kugelsymmetrischen Elektrodenanordnungen sind jedoch schwierig und aufwendig herzustellen.

Der vorliegenden Erfindung liegt die Aufgabe zugrunde, ein elektrostatisches Gegenfeld-Spektrometer der eingangs genannten Art anzugeben, welches eine größere Raumwinkelverteilung der am Meßpunkt an der Probenoberfläche ausgelösten Sekundärelektronen transmittieren kann und welches relativ einfach hergestellt werden kann.

Diese Aufgabe wird erfindungsgemäß durch ein elektrostatisches Gegenfeld-Spektrometer nach dem Anspruch 1 gelöst. Ausgestaltungen und Vorteile der Erfindung sind in den Unteransprüchen, der Beschreibung und der Zeichnung dargestellt.

Bei einem Gegenfeld-Spektrometer nach dem Stand der Technik waren bei Verwendung von im wesentlichen ebenen Gegenfeld-Elektroden die Äquipotentiallinien im Gegenfeld im wesentlichen ebenfalls eben. Dadurch, daß bei einem elektrostatischen Gegenfeld-Spektrometer nach der Erfindung Elektrodenteile vorhanden sind, deren Abstand vom Primärkorpuskularstrahl in Richtung zur Absaugelektrode hin verkleinert sind, sind die Äquipotentiallinien innerhalb der Gegenfeld-Elektrodenanordnung nicht mehr im wesentlichen eben wie beim Stand der Technik, sondern so gekrümmt, daß die Winkelverteilung der Sekundärkorpuskeln (Sekundärelektronen) wenigstens teilweise berücksichtigt wird.

Im Idealfall besteht bei einem Gegenfeld-Spektrometer nach der Erfindung die Gegenfeld-Elektrodenanordnung aus einem massiv ausgeführten Elektrodenteil, das eine kreiskegelstumpfförmige zentrale Bohrung aufweist. Die kleinere Öffnung der kreiskegelstumpf-förmigen Innenbohrung dieses Elektrodenteils weist dabei in Richtung zur Absaugelektrode hin. Die Mantelfläche des Kreiskegelstumpfes weist dabei vorteilhafterweise mit der Richtung des Primärkorpuskelstrahls einen Winkel von 45° auf. Wenn, in Richtung des Primärkorpuskelstrahls gesehen, sowohl die obere als auch die untere Öffnung der kreiskegelstumpf-förmigen Bohrung des Elektrodenteils jeweils mit einer ebenen Gegenfeld-Elektrode versehen sind, sind die Äquipotentiallinien im Inneren einer solchen Gegenfeld-Elektrodenanordnung praktisch kugelsymmetrisch. Eine solche Gegenfeld-Elektrodenanordnung nach der Erfindung ist einfach herzustellen und liefert eine bessere Energieauflösung als dies nach dem Stand der Technik möglich gewesen ist.

Das äußere Elektrodenteil bzw., wenn es aus mehreren verschiedenen Teilen zusammengesetzt ist, die äußeren Elektrodenteile begrenzen die Bahnen von Rückstreuelektronen so, daß die Rückstreuelektronen nicht an die Wände desjenigen Spektrometerteils gelangen können, in dem sich eine Öffnung zum Detektor hin befindet. Damit ist erreicht, daß die Rückstreuelektronen auch nicht den Detektor erreichen und somit auch das Meßsignal nicht verfälschen können.

Die äußeren Elektrodenteile bei einer Gegenfeld-Elektrodenanordnung nach der Erfindung ermöglichen es, daß die Potentialverteilung im Inneren der Gegenfeld-Elektrodenanordnung besser als beim Stand der Technik möglich definiert ist. Je massiver die äußeren Elektrodenteile ausgeführt sind, um so besser ist die Potentialverteilung im Inneren der Gegenfeld-Elektrodenanordnung definiert.

Die zentrale Bohrung im Inneren der äußeren Elektrodenteile der Gegenfeld-Elektrodenanordnung muß nicht unbedingt zylindrisch sein. Diese zentrale Bohrung kann auch so gestaltet sein, daß geometrische Besonderheiten der übrigen Spektrometer-Detektoranordnung berücksichtigt werden.

Ein Ausführungsbeispiel der Erfindung ist in der Zeichnung dargestellt und wird im folgenden näher erläutert.

Figur 1 zeigt ein bekanntes elektrostatisches Gegenfeld- Spektrometer nach dem Stand der Technik.

Figur 2 zeigt eine Ausführungsform eines erfindungsgemäßen elektrostatischen Gegenfeld-Spektrometers.

Figur 3 erläutert eine vorteilhafte Wirkung eines erfindungsgemäßen elektrostatischen Gegenfeld-Spektrometers.

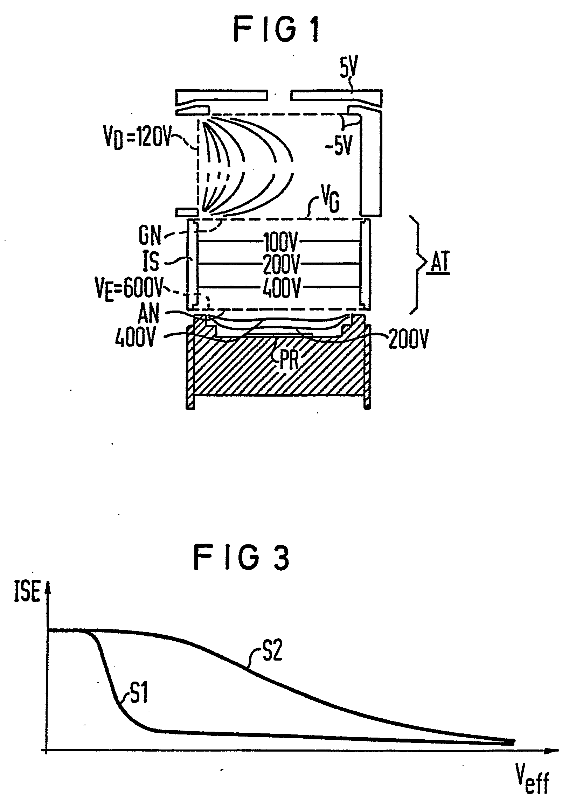

Figur 1 zeigt ein bekanntes Gegenfeld-Spektrometer nach dem zitierten Stand der Technik von H.P. Feuerbaum. Um zu einer erfindungsgemäßen Ausführungsform zu gelangen, muß das auszutauschende Teil AT durch ein Teil ersetzt werden, welches erfindungsgemäße Merkmale aufweist. Das auszutauschende Teil AT weist ein Absaugnetz AN, ein Gegenfeld-Netz GN und einen Isolator IS auf. Das auszutauschende Teil AT befindet sich oberhalb der Probe PR, auf deren Oberfläche Meßpunkte zu vermessen sind. Das auszutauschende Teil AT von Figur 1 wird bei der Ausführungsform nach Figur 3 durch das erfindungsgemäße Teil ET3 ersetzt.

Wenn ein Gegenfeld-Netz GN bei einem bekannten Gegenfeld- Spektrometer nach Figur 1 eine Maschenweite von 250 µm und eine für den Primärelektronenstrahl zentrische Bohrung mit einem Durchmesser von 0,5 mm aufweist, wenn am Absaugnetz AN ein Potential von 600 V anliegt und wenn am Gegenfeld-Netz GN ein Potential von 0 V anliegt, so wird bei einem Gegenfeld-Spektrometer nach Figur 1 in der für den Primärelektronenstrahl vorhandenen zentrischen Bohrung eine maximale Feldstärke von 30 V gemessen. Dies bedeutet, daß bei einem Gegenfeld-Spektrometer nach Figur 1 bei den angenommenen Werten für die Potentiale und bei den angenommenen Abmessungen für das Gegenfeld-Netz GN auch noch solche Sekundärelektronen vom Detektor nachgewiesen werden können, die nicht die Potentialbarriere von 600 V, die zwischen dem Absaugnetz AN und dem Gegenfeld-Netz GN vorhanden ist, überwinden können, sondern die lediglich die Differenz zwischen dem Potential von 600 V am Absaugnetz AN und dem Potential von 30 V in der für den Primärelektronenstrahl zentrischen Bohrung des Gegenfeld-Netzes GN überwinden können. Dadurch werden die Meßergebnisse verfälscht. Dadurch ist die Energieauflösung relativ schlecht. Selbst wenn das ebene Gegenfeld-Netz GN beim Gegenfeld-Spektrometer nach Figur 1 durch zwei parallele, ebene Gegenfeld-Netze ersetzt werden würde, die ihrerseits jeweils eine Maschenweite von 250 µm und jeweils eine zentrische Bohrung mit einem Durchmesser von jeweils 0,5 mm hätten, wenn diese beiden parallelen Gegenfeld-Netze einen Abstand zueinander von 1 mm hätten, wenn diese beiden parallelen Gegenfeld-Netze auf einem Potential von 0 V liegen würden und wenn die Absaugelektrode wiederum auf einem Potential von 600 V liegen würde, so würde in den zentrischen Bohrungen der beiden parallelen Gegenfeld-Netze immer noch eine maximale Feldstärke von 4 V gemessen werden können. Auch in diesem Fall wären die Meßergebnisse und wäre damit die Energieauflösung schlecht. Außerhalb der zentrischen Bohrungen der beiden parallelen Gegenfeld-Netze würden die Äquipotentiallinien zwischen diesen beiden parallelen Gegenfeld-Netzen im wesentlichen parallel verlaufen.

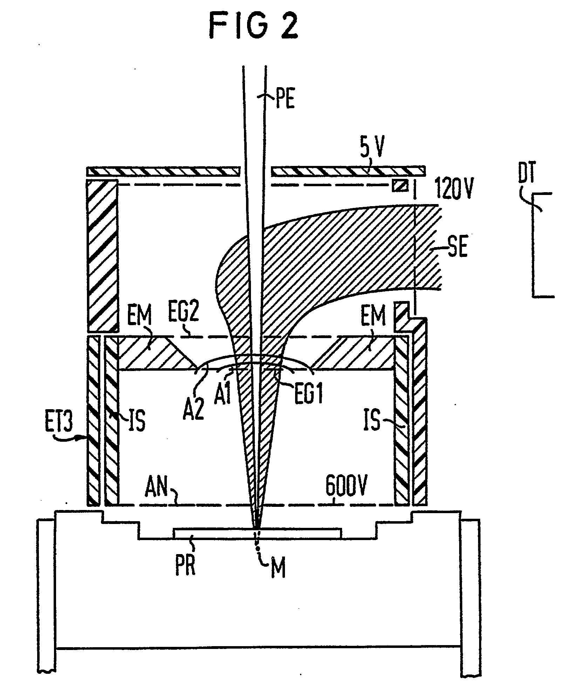

Figur 2 zeigt eine Ausführungsform eines erfindungsgemäßen elektrostatischen Gegenfeld-Spektrometers. Beim erfindungsgemäßen Teil ET3 von Figur 2 wird ein praktisch kugelsymmetrisches Gegenfeld zwischen den beiden parallelen, ebenen Gegenfeld-Netzen EG1, EG2 erzeugt. Die Gegenfeld-Elektrodenanordnung besteht aus einem massiven äußeren Elektrodenteil EM. Dieses massive äußere Elektrodenteil EM besitzt eine kreiskegelstumpf-förmige Innenbohrung. Die zur Absaugelektrode AN hin gerichtete Öffnung dieser Innenbohrung ist mit dem ebenen Gegenfeld-Netz EG1 versehen. Die zur Quelle des Primärelektronenstrahls PE hin gerichtete Öffnung dieser inneren Bohrung ist mit dem ebenen GegenfeldNetz EG2 versehen. Beide ebenen Netze EG1, EG2 besitzen jeweils eine Maschenweite von 250 µm und jeweils eine zentrische Innenbohrung mit jeweils einem Durchmesser von 0,5 mm. Das massive äußere Elektrodenteil besteht aus vergoldeter Bronze. Die beiden ebenen Gegenfeld-Netze EG1, EG2 bestehen jeweils aus vergoldetem Kupfer. Sämtliche Teile der Gegenfeld-Elektrodenanordnung, nämlich das massive äußere Elektrodenteil EM und die ebenen Gegenfeld-Netze EG1, EG2 befinden sich jeweils auf demjenigen Potential, auf das die Gegenfeld- Elektrode im Verlauf einer Messung gerade gelegt wird. Das massive äußere Elektrodenteil EM hat einen äußeren Durchmesser von etwa 8 mm, eine Höhe von etwa 1 mm, eine kleinere Öffnung der Innenbohrung von etwa 3 mm und eine größere Öffnung der Innenbohrung von etwa 6 mm. Der Durchmesser des ebenen Gegenfeld-Netzes EG1 ist gleich dem Durchmesser der kleineren Öffnung der Innenbohrung und damit gleich 3 mm. Der Durchmesser des größeren ebenen Gegenfeld- Netzes EG2 ist gleich dem Durchmesser der größeren Öffnung der Innenbohrung des massiven äußeren Elektrodenteils EM und damit gleich 6 mm. Der Mantel der kreiskegelstumpfförmigen Innenbohrung des äußeren Elektrodenteils EM schließt mit der Richtung des Primärelektronenstrahls PE einen Winkel von 45° ein. Die Äquipotentiallinien A1 und A2 im Inneren der Gegenfeld-Elektrodenanordnung sind im Idealfall praktisch kugelsymmetrisch zum virtuellen Quellpunkt M, damit die Bahnen der Sekundärelektronen SE im Inneren der Gegenfeld-Elektrodenanordnung unabhängig von ihrer Winkelverteilung praktisch parallel zu den Feldlinien verlaufen.

Die vorteilhafte Wirkung eines Gegenfeld-Spektrometers nach der Erfindung wird bereits dadurch erreicht, daß der Abstand der Innenwand des äußeren Elektrodenteils EM vom Primärelektronenstrahl PE in Richtung zur Absaugelektrode AN hin verkleinert wird. Dadurch sind bereits die wesentlichen Vorteile einer Gegenfeld-Elektrodenanordnung nach der Erfindung gegeben. Diese wesentlichen Vorteile bleiben auch dann erhalten, wenn die Gegenfeld-Elektroden EG1, EG2 nicht vollkommen eben, sondern ein wenig gewölbt ausgeführt sind. Statt der beiden Gegenfeld-Elektroden EG1, EG2 kann auch nur eine oder können mehrere Gegenfeld-Elektroden im Bereich der Innenbohrung des äußeren Elektrodenteils EM vorgesehen sein. Wichtig ist, daß das Innere des äußeren Elektrodenteils EM ebenfalls metallische Teile aufweist, die auf demselben Potential wie das äußere Elektrodenteil EM liegen. Ohne solche metallischen Teile im Inneren der Innenbohrung des äußeren Elektrodenteils EM würde im Inneren der Gegenfeld- Elektrodenanordnung eine maximale Feldstärke von etwa 50 oder 60 V gemessen werden mit entsprechenden ungünstigen Auswirkungen auf die Meßergebnisse und auf die Energieauflösung. Wichtig bei einer Gegenfeld-Elektrodenanordnung nach der Erfindung ist, daß die im Inneren der Gegenfeld-Elektrodenanordnung gemessene maximale Feldstärke kleiner ist als bei einer Gegenfeld-Elektrodenanordnung nach dem Stand der Technik, bei der keine Elektrodenteile vorhanden sind, deren Abstände zum Primärelektronenstrahl PE sich in Richtung zur Absaugelektrode AN hin verkleinern.

Bei einer Gegenfeld-Elektrodenanordnung nach der Erfindung ist die maximale Feldstärke im Inneren der Gegenfeld-Elektrodenanordnung im Vergleich zum Stand der Technik nach Fig.1 um den Faktor 15 gesenkt. Dies bedeutet eine Verbesserung der Energieauflösung um einen Faktor zwischen 200 und 250.

Figur 3 erläutert eine vorteilhafte Wirkung eines Gegenfeld- Spektrometers nach der Erfindung. Ein Gegenfeld-Spektrometer nach der Erfindung besitzt die Spektrometer-Kennlinie S1, ein Gegenfeld-Spektrometer nach dem Stand der Technik besitzt die Spektrometer-Kennlinie S2. Veff ist die Potentialbarriere zwischen dem Meßpunkt und dem Potential der Äquipotentiallinie A2. Das Potential der Äquipotentiallinie A2 wird über das Potential der Gegenfeld-Elektrodenanordnung so eingestellt, daß die niederenergetischen Sekundärelektronen SE, die von lokalen Feldern auf der Probe PR beeinflußt sind, nicht zum Detektor DT gelangen. ISE ist das Sekundärelektronen-Meßsignal, das man aus dem Strom derjenigen Sekundärelektronen SE erhält, die die Potentialbarriere zwischen dem Potential am Meßpunkt und dem Potential der Äquipotentiallinie A2 überwinden und zum Detektor DT gelangen können. Die Spektrometer-Kennlinie S1 für ein Gegenfeld-Spektrometer nach der Erfindung fällt in einem sehr kleinen Bereich von Veff ziemlich steil ab. Die Spektrometer-Kennlinie S2 zeigt einen relativ sanften Abfall in einem relativ großen Bereich von Veff. Damit kann bei einem Gegenfeld-Spektrometer nach der Erfindung das Potential eines Meßpunktes sehr viel genauer bestimmt werden als mit einem Gegenfeld-Spektrometer nach dem Stand der Technik. Damit ist die Energieauflösung mit einem Gegenfeld-Spektrometer nach der Erfindung wesentlich größer als mit einem Gegenfeld-Spektrometer nach dem Stand der Technik.

Die Absaugelektrode AN und die Gegenfeld-Elektrodenanordnung sind durch Isolatoren IS getrennt.

**Patentansprüche**

1. Elektrostatisches Gegenfeld-Spektrometer mit einer eine erste ebene oder gewölbte Gegenfeld-Elektrode (EG1) aufweisenden Gegenfeld-Elektrodenanordnung zur Erzeugung eines elektrischen Gegenfeldes und einer Absaugelektrode (AN) zur Beschleunigung der von einem primären Korpuskularstrahl (PE) auf einer Probe (PR) ausgelösten Sekundärkorpuskel (SE) in Richtung der Gegenfeld-Elektrodenanordnung dadurch gekennzeichnet, daß die Gegenfeld-Elektrodenanordnung einen Elektrodenteil (EM) mit einer sich in Richtung der Absaugelektrode (AN) verjüngenden Bohrung aufweist und daß die erste Gegenfeld-Elektrode (EG1) die Bohrung an der der Absaugelektrode (AN) zugewandten oder abgewandten Seite abschließt.

2. Elektrostatisches Gegenfeld-Spektrometer nach Anspruch 1, dadurch gekennzeichnet, daß die erste Gegenfeld-Elektrode (EG1) als Netzelektrode ausgeführt ist.

3. Elektrostatisches Gegenfeld-Spektrometer nach Anspruch 1 oder 2, dadurch gekennzeichnet, daß der Elektrodenteil (EM) eine kegelstumpfförmige Bohrung aufweist.

4. Elektrostatisches Gegenfeld-Spektrometer nach Anspruch 3, gekennzeichnet durch eine kreiskegelstumpfförmige Bohrung des Elektrodenteils (EM).

5. Elektrostatisches Gegenfeld-Spektrometer nach einem der Ansprüche 1 bis 4, gekennzeichnet durch eine zweite ebene oder gewölbte Gegenfeld-Elektrode (EG2), die auf der der ersten Gegenfeld-Elektrode (EG1) gegenüberliegenden Seite der Bohrung angeordnet ist.

6. Elektrostatisches Gegenfeld-Spektrometer nach einem der Ansprüche 1 bis 5, gekennzeichnet durch eine ebene Absaugelektrode (AN).

7. Elektrostatisches Gegenfeld-Spektrometer nach einem der Ansprüche 1 bis 6, dadurch gekennzeichnet, daß die Absaugelektrode (AN) als Netzelektrode ausgeführt ist.

**Claims**

1. Electrostatic counterfield spectrometer with a counterfield electrode arrangement having a first plane or curved counterfield electrode (EG1) to generate an electrical counterfield and a collector electrode (AN) to accelerate the secondary corpuscles (SE) released by a primary corpuscular beam (PE) on a test piece (PR) in the direction of the counterfield electrode arrangement, characterised in that the counterfield electrode arrangement has an electrode part (EM) with a bore which tapers in the direction of the collector electrode (AN), and the first counterfield electrode (EG1) closes off the bore on the side facing towards or away from the collector electrode (AN).

2. Electrostatic counterfield spectrometer as claimed in claim 1, characterised in that the first counterfield electrode (EG1) is constructed as a grid electrode.

3. Electrostatic counterfield spectrometer as claimed in claim 1, characterised in that the electrode part (EM) has a bore in the shape of a circular truncated cone.

4. Electrostatic counterfield spectrometer as claimed in claim 3, characterised by a bore in the shape of a circular truncated cone in the electrode part (EM).

5. Electrostatic counterfield spectrometer as claimed in one of claims 1 to 4, characterised by a second plane or curved counterfield electrode (EG2) which is arranged on the side of the bore lying opposite the first counterfield electrode (EG1).

6. Electrostatic counterfield spectrometer as claimed in one of claims 1 to 5, characterised by a plane collector electrode (AN).

7. Electrostatic counterfield spectrometer as claimed in one of claims 1 to 6, characterised in that the collector electrode (AN) is constructed as a grid electrode.

**Revendications**

1. Spectromètre électrostatique à champ antagoniste, comprenant une structure d'électrode à champ antagoniste qui comporte une première électrode plane ou incurvée (EG1) et qui est destinée à produire un champ électrique antagoniste, ainsi qu'une électrode d'extraction (AN) qui est destinée à accélérer les corpuscules secondaires (SE) arrachés par un faisceau de corpuscules primaires (PE) sur un échantillon (PR), l'accélération se faisant vers la structure d'électrode à champ antagoniste, caractérisé en ce que la structure d'électrode à champ antagoniste comprend un élément (EM) présentant un trou se rétrécissant vers l'électrode d'extraction (AN) et la première électrode à champ antagoniste (EG1) ferme le trou du côté tourné vers l'électrode d'extraction (AN) ou du côté opposé.

2. Spectromètre électrostatique à champ antagoniste selon la revendication 1, caractérisé en ce que la première électrode à champ antagoniste (EG1) est en forme de réseau ou de grille.

3. Spectromètre électrostatique à champ antagoniste selon la revendication 1 ou 2, caractérisé en ce que ledit élément d'électrode (EM) comporte un trou tronconique.

4. Spectromètre électrostatique à champ antagoniste selon la revendication 3, caractérisé en ce que le trou tronconique dudit élément d'électrode (EM) est de section circulaire.

5. Spectromètre électrostatique à champ antagoniste selon l'une quelconque des revendications 1 à 4, caractérisé par une seconde électrode plane ou incurvée à champ antagoniste (EG2) qui est disposée du côté du trou qui est à l'opposé de celui sur lequel se trouve la première électrode à champ antagoniste (EG1).

6. Spectromètre électrostatique à champ antagoniste selon l'une quelconque des revendications 1 à 5, caractérisé par une électrode d'extraction plane (AN).

7. Spectromètre électrostatique à champ antagoniste selon l'une quelconque des revendications 1 à 6, caractérisé en ce que l'électrode d'extraction (AN) a la forme d'un réseau ou d'une grille.

# F I G 1

# F I G 3

# FIG 2